# EUROPEAN PATENT APPLICATION

(11) **EP 4 307 564 A1**
(43) Date of publication of application: **17.01.2024**
(21) Application number: 22184118.2
(22) Date of filing: 11.07.2022
(51) Int. Cl.: H03K 17/945, H03K 17/955, G01S 11/02, H01Q 1/24, H04B 1/3827

(54) **PROXIMITY SENSOR DEVICE AND METHOD FOR DETERMINING A PROXIMITY OF BODY TISSUE RELATIVE TO AN ANTENNA**

(71) Applicant: Infineon Technologies AG, 85579 Neubiberg (DE)
(72) Inventor: KARPIN, Oleksandr, 79059 Lviv (UA); KRAVETS, Igor, 79060 Lviv (UA); SOLOMKO, Valentyn, 81479 München (DE); TAYARI, Danial, 82008 Unterhaching (DE); WANG, Kun, 85635 Höhenkirchen-Siegertsbrunn (DE)
(74) Representative: Hersina, Günter

(57) **Abstract**

Disclosed herein is a proximity sensor device (501) comprising at least one antenna (502) for transmitting and/or receiving radio frequency waves, a radio frequency voltage sensor (503) configured to determine a variable radio frequency voltage distribution at the antenna (502), wherein the radio frequency voltage distribution varies in presence of a body tissue (507), and a controller (505) configured to determine a proximity of the body tissue (507) relative to the antenna (502) based on the determined radio frequency voltage distribution. Further, a corresponding method for determining a proximity of body tissue (507) relative to an antenna (502), by using the proximity sensor device (501), is suggested.

## Description

Embodiments of the present disclosure relate to a proximity sensor device for determining a proximity of body tissue relative to an antenna. The antenna may be part of an electronic device that is capable of transmitting and/or receiving electromagnetic radiation, such as a mobile phone or the like.

### TECHNICAL BACKGROUND

Wireless devices, such as mobile phones, smartphones and the like, emit radio frequency (RF) radiation that may be absorbed by human tissue. By today it is still not fully explored how RF radiation affects human body tissue and, thus, human health. However, what is known is the fact that the closer human tissue is positioned to a high frequency antenna the more harmful radiation will be absorbed.

However, in order to keep absorption of RF radiation by human tissue at an uncritical level, certain government regulations (e.g. Specific Absorption Rate - SAR) exist to limit the maximum RF energy being absorbed by human tissue. For this purpose, modern wireless devices may be equipped with a proximity sensor for detecting whether human tissue is in proximity of the wireless device, i.e. within the radiating field of the wireless device.

For example, when it is detected that a human body is moving close to the wireless device's transmitting antenna, the wireless device needs to reduce the transmitted RF power to a certain uncritical level so as to meet the regulations. At the moment, conventional proximity sensors (SAR sensors) for this purpose are mostly using a capacitive sensing technology that uses mobile antennas as part of the sensor.

Capacitive sensors may be easy to install and widely available at low cost. However, sensitivity of such capacitive sensors decreases with increasing distance between the capacitive structure and the human body. In result, the output power of a wireless device may be reduced by some unnecessary amount, which negatively impacts the quality of the wireless connection.

Stated differently, it is often desirable to operate a wireless device at its maximum transmit power so as to ensure high quality wireless connections. However, if human tissue is in proximity of the wireless device, regulations may stipulate to reduce the transmit power. If a proximity sensor's sensitivity is low, it may happen that the sensor may incorrectly detect the distance between the wireless device and the human tissue. Thus, transmit power may be reduced too much because the sensor assumes that the human tissue is closer to the wireless device than it actually is. With respect to capacitance sensors, their sensitivity may degrade with increasing distance of the human body. That means, the larger the distance between the wireless device and the human body, the more inaccurate the sensor's distance measurements may become.

Thus, it would be desirable to improve existing proximity sensors in a way to provide high sensitivity over a wide proximity range thereby improving the proximity measurements leading to a more accurate regulation of a wireless device's transmit power. Accordingly, a wireless device being equipped with a proximity sensor according to the herein described innovative principle may operate more efficiently in terms of wireless transmission quality and battery life.

In order to achieve these goals, a proximity sensor as well as a method for determining a proximity of body tissue relative to an antenna in accordance with the appended independent claims are suggested. Further embodiments and advantageous aspects are suggested in the dependent claims.

The herein described innovative proximity sensor comprises at least one antenna for transmitting and/or receiving radio frequency waves, a radio frequency voltage sensor configured to determine a variable radio frequency voltage distribution at the antenna, wherein the radio frequency voltage distribution varies in presence of a body tissue, and a controller configured to determine a proximity of the body tissue relative to the antenna based on the determined radio frequency voltage distribution.

The herein described innovative method for determining a proximity of body tissue relative to an antenna comprises steps of providing at least one antenna for transmitting and/or receiving radio frequency waves, determining a variable radio frequency voltage distribution of the antenna, wherein the radio frequency voltage distribution varies in presence of a body tissue, and determining a proximity of the body tissue relative to the antenna based on the determined radio frequency voltage distribution.

According to a further aspect, computer programs are provided, wherein each of the computer programs is configured to implement the herein-described method when being executed on a computer or signal processor, so that the above-described method is implemented by one of the computer programs.

In the following, embodiments of the present disclosure are described in more detail with reference to the figures, in which
- Fig. 1A: shows a schematic sketch of a varying distance between a user's hand and an antenna,
- Fig. 1B: shows an exemplary measurement of a varying capacitance of a capacitance sensor in response to a varying distance between a user's hand and an antenna,
- Fig. 2: shows a schematic block diagram of a capacitive SAR sensor,
- Fig. 3: shows a further schematic block diagram of a capacitive SAR sensor,
- Fig. 4: shows a further schematic block diagram of a capacitive SAR sensor in presence of a human body,
- Fig. 5A: shows a schematic block diagram of a proximity sensor device comprising an RF voltage sensor according to an embodiment,
- Fig. 5B: shows a further schematic block diagram of a proximity sensor device comprising an RF voltage sensor and a transmitter according to an embodiment,
- Fig. 5C: shows a further schematic block diagram of a proximity sensor device comprising an RF voltage sensor and an optional capacitance sensor according to an embodiment,
- Fig. 6: shows a further schematic block diagram of a proximity sensor device according to an embodiment,
- Fig. 7: shows a graph for comparing the sensitivity of a RF voltage sensor with the sensitivity of a capacitance sensor,
- Fig. 8: shows a further schematic block diagram of a proximity sensor device according to an embodiment,
- Fig. 9A: shows a simulation of a user's hand and a wireless device being equipped with a proximity sensor device according to an embodiment,
- Fig. 9B: shows an enlarged view of Fig. 9A,
- Fig. 9C: shows a further simulation of a user's hand with varying distance to a wireless device being equipped with a proximity sensor device according to an embodiment, and
- Fig. 9D: shows three graphs showing different RF voltage distributions of an antenna being measured at three different feeding positions.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

In the following, proximity sensors may be described by exemplarily referring to so-called SAR sensors (SAR: Specific Absorption Rate). However, if reference to SAR sensors is made herein, they shall be construed as merely exemplary. Other kinds of proximity sensors are also subsumed and covered by the term SAR sensor.

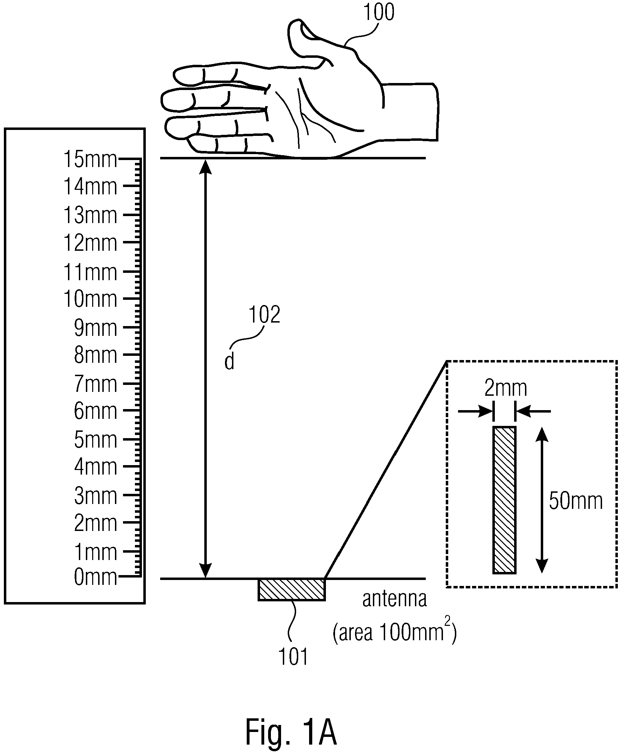

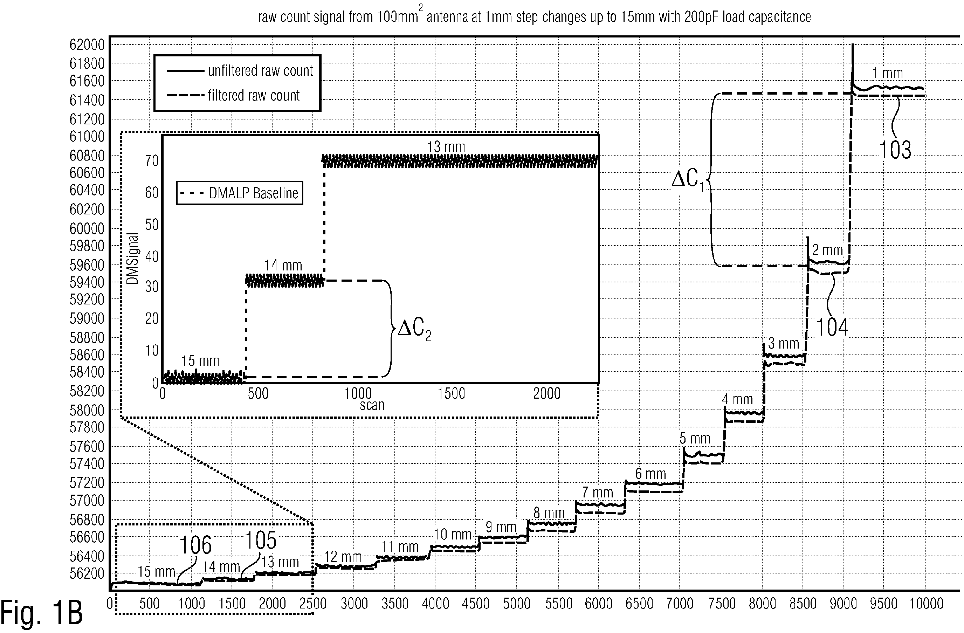

For introductory purposes, Figures 1A and 1B show the general concept of determining a body tissue by means of a capacitive proximity sensor. Figure 1A shows a schematic sketch of a user's hand 100 being in proximity to an antenna 101 which may be integrated in a wireless device (not shown). As will be described in more detail further below, the antenna 101 may be used as a capacitive element for determining a distance 'd' (see reference numeral 102) to the user's hand 100.

In this non-limiting example, the antenna 101 may comprise a length of 50 mm and a width of 2 mm resulting in an overall active radiating area of 100 mm². With varying distance 102 between the user's hand relative to the antenna 101 (capacitive element), the capacitance of the antenna 101 may vary. As can be seen in Figure 1B, the capacitance values vary as a function of the distance 102. For example, if the user's hand 100 was only 1 mm away from the antenna 102 (capacitive element), the capacitance had its highest value, as indicated by the measurement value referenced with numeral 103. If the user's hand 100 was 2 mm away from the antenna 102 (capacitive element), the capacitance had its second highest value, as indicated by the measurement value referenced with numeral 104.

As can be seen in Figure 1B, the capacitance decreases with increasing distance 102 between the user's hand 100 and the antenna 101 (capacitive element). Towards the end of this exemplary scale, i.e. at a distance 102 of 14 mm and 15 mm, the measured capacitance significantly decreased, as indicated by reference numerals 105, 106.

As can further be seen in Figure 1B, the differential capacitance between two consecutive or adjacent measurements significantly decreases with increasing distance 102. For example, the differential capacitance ΔC₁ between the first and second measurement values 103, 104 at a distance 102 of 1 mm and 2 mm, respectively, is larger than the differential capacitance ΔC₂ between the ultimate and penultimate measurement values 105, 106 at a distance 102 of 14 mm and 15 mm, respectively. This is an indication that the sensitivity of the capacitive proximity sensor, using the antenna 101 as a capacitive element, drastically decreases with increasing distance 102. As a result, the resolution of the capacitive proximity sensor deteriorates with increasing distance which may lead to faulty distance measurements.

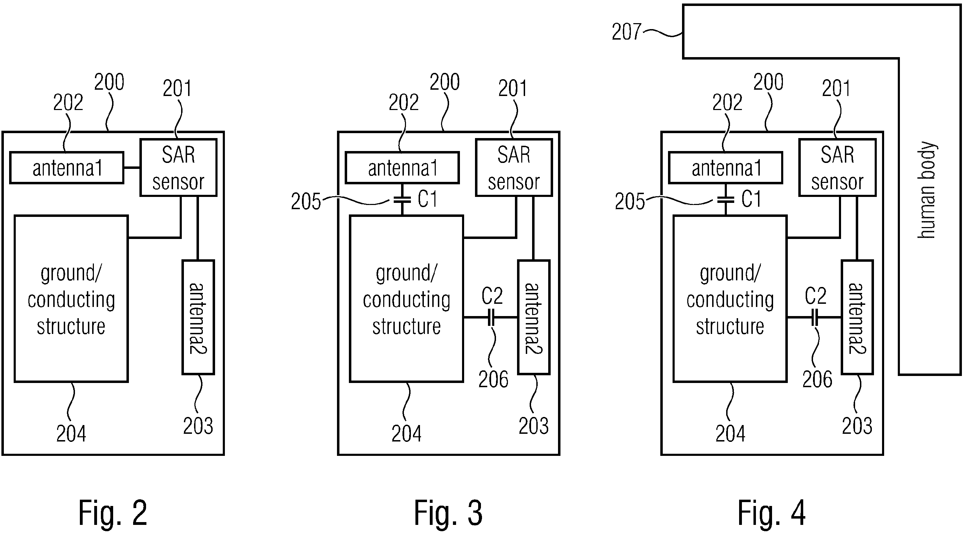

Figure 2 shows an example of a capacitive proximity sensor 201 (SAR sensor) that may be used in a wireless communication device 200, such as in a smartphone or the like. The wireless communication device 200 may comprise one or more antennas 202, 203 for transmitting or receiving RF signals.

The antennas 202, 203 may form a capacitive structure in connection with a further conducting structure, such as a PCB ground or any other conducting structure 204 of the wireless device 200. For example, Figure 3 shows a first capacitance C1, indicated by reference numeral 205, and a second capacitance C2, indicated by reference numeral 206.

Figure 4 shows a portion of a human body 207, or human body tissue, in vicinity to the wireless device 100. The above described capacitances C1 (205) and C2 (206) would now slightly vary in response to the human body 207 moving closer to and farther from the wireless device 200, respectively.

Surprisingly, the authors of the herein described innovative concept found that the radio frequency (RF) voltage distribution at the antennas 202, 203 is also varying in response to the varying distance between the human body 207 and the wireless device 200.

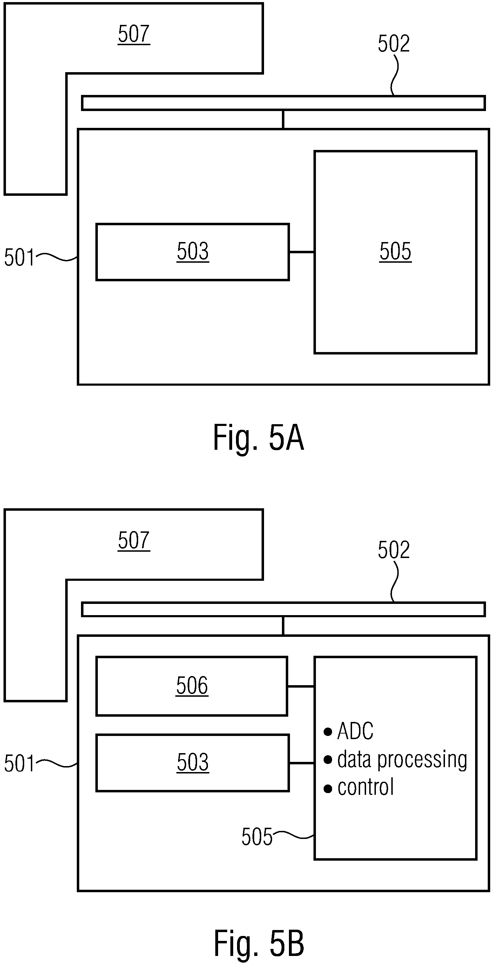

Figure 5A shows a first embodiment of a proximity sensor device 501 according to the herein described innovative principle. The proximity sensor device 501 may substantially correspond to the above described SAR sensor 201 and may also be mounted inside a wireless device (not shown). However, the proximity sensor device 501 of the present innovative concept may not make use of the capacitive sensing principle, as described above with reference to Figures 2 to 4. Instead, the proximity sensor device 501 may exploit the RF voltage distribution of at least one antenna 502 for determining a distance / proximity to a user's body tissue (e.g. hand, head, ear, etc.).

Therefore, the proximity sensor device 501 may be connected to said at least one antenna 502 for transmitting and/or receiving radio frequency waves. The proximity sensor device 501 may further comprise a radio frequency voltage sensor 503 that is configured to determine a variable radio frequency voltage distribution at the antenna 502. The radio frequency voltage distribution at the antenna 502 varies in presence of a body tissue 507, similar to the capacitance described above. Accordingly, the RF voltage distribution at the antenna 502 varies depending on the proximity or distance between the body tissue 507 and the antenna 502.

The proximity sensor device 501 may further comprise a controller 505. The controller 505 may be configured to determine a distance / proximity of the body tissue 507 relative to the antenna 502 based on the determined radio frequency voltage distribution.

The controller 505 may be configured to determine the exact distance between the body tissue 507 and the antenna 502 based solely on the measured RF voltage distribution at the antenna 502. More particularly, the controller 505 may be configured to measure the RF voltage distribution at the antenna 502 and to interpret the obtained measurement values of the RF voltage distribution as a distance between the body tissue 507 and the antenna 502. Accordingly, the controller 505 may determine a quantifiable distance value, for instance in terms of millimeters, e.g. 1 mm, 2 mm, 3 mm, ..., etc. In other words, a first measured RF voltage distribution value U_{RF1} (e.g. 75 V) may correspond to a first distance value d₁ (e.g. 1 mm), while a different second measured RF voltage distribution value U_{RF2} (e.g. 79 V) may correspond to a different second distance value d₂ (e.g. 10 mm).

Figure 5B shows a further embodiment in which the proximity sensor device 501 further comprises a transmitter 506 for generating a transmit power to be fed to the antenna 502. The controller 505 may be configured to adjust the transmit power of the transmitter 506 depending on the determined proximity of the body tissue 507 relative to the antenna 502. This can be useful in order to meet regulatory restrictions like the Specific Absorption Rate (SAR). The controller 505 may control the transmit power to meet such regulatory restrictions. For instance, the controller 505 may reduce the transmit power if it is too high, i.e. if it is above a threshold value stipulated by the respective regulatory restriction. Additionally or alternatively, the controller 505 may increase the transmit power if it is too low, i.e. if it is below the threshold value stipulated by the respective regulatory restriction.

The above mentioned threshold may be different at different proximities / distances between the body tissue 507 and the antenna 502. The farther away the body tissue 507 is from the antenna 502, the higher the transmit power may be adjusted by the controller 505. For example, if the body tissue 507 has a first proximity / distance (e.g. 10 mm) to the antenna 502, then the controller 505 may adjust the transmit power to a first value (e.g. 100 mW). If the body tissue 507 has a shorter second proximity / distance (e.g. 5 mm) to the antenna 502, then the controller 505 may adjust the transmit power to a lower second value (e.g. 75 mW).

Accordingly, the controller 505 may be configured to provide different transmit powers at different proximities / distances of the body tissue 507 relative to the antenna 502. In this regard, two cases may occur:
If the provided transmit power at a certain proximity / distance exceeds a transmit power threshold, then the controller 505 may be configured to decrease the transmit power to a predetermined value that is at or below said transmit power threshold.

In turn, if the provided transmit power at said certain proximity / distance is below the transmit power threshold, then the controller 505 is configured to increase the transmit power to said predetermined value that is at or below the transmit power threshold.

The controller 505 may be configured to adjust the transmit power to a predetermined value that exactly corresponds to the respective transmit power threshold at the respective proximity / distance. In this case, the transmit power may always be operated at its optimum while regulatory restrictions are met.

The controller 505 may be configured to adjust the transmit power to a predetermined value that is 0 % to 20 % below the transmit power threshold. In this case, the transmit power may still have a good operating point and regulatory restrictions are met. For example, if the transmit power threshold is 100 mW, then the controller 505 may adjust the transmit power to 80 mW to 100 mW.

Accordingly, the controller 505 may dynamically adjust the transmit power, e.g. to meet a certain SAR value. For example, at a distance/proximity of X mm, it is allowed (according to SAR) to transmit with power 'X'. If the proximity sensor device 501 detects that the transmitter 506 transmits with power Y > X, then the controller 505 may decrease the transmit power until reaching the maximum allowed power. If proximity sensor device 501 detects that the transmitter 506 transmits with power Y < X, then the controller 505 may increase the transmit power until reaching the maximum allowed power.

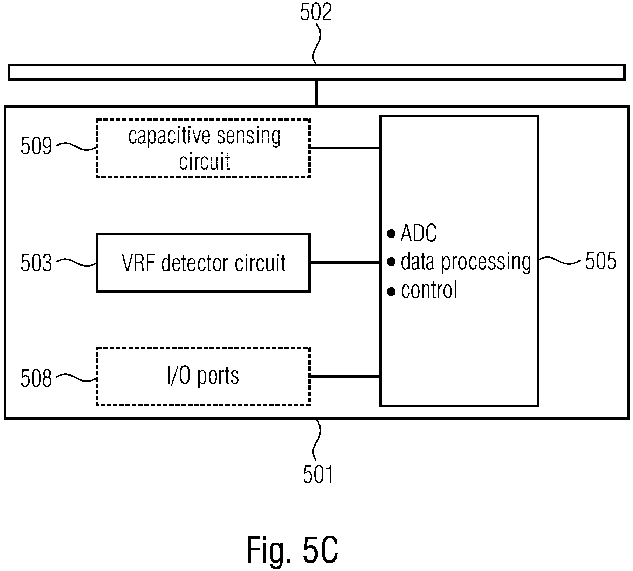

Figure 5C shows a further embodiment, in which the proximity sensor device 501 may comprise some further optional components. Optional components or elements are shown in dashed lines. For example, in addition to the above described controller 505, the antenna 502 and the RF voltage sensor 503, the proximity sensor device 501 may optionally comprise one or more I/O ports 508. Additionally or alternatively, the proximity sensor device 501 may optionally comprise a capacitance sensor 509, similar to the capacitive sensor 201 as discussed above with reference to Figures 2 to 4.

The controller 505 may provide different functions, such as an Analog-to-Digital Converter (ADC), data processing, e.g. for processing data of the RF voltage sensor 503 and / or the capacitive sensor 509, and control functions, e.g. for controlling the transmit power as a function of the proximity / distance between the body tissue 507 and the antenna 502, as described above. These features of the controller 505 hold for each and every embodiment discussed herein.

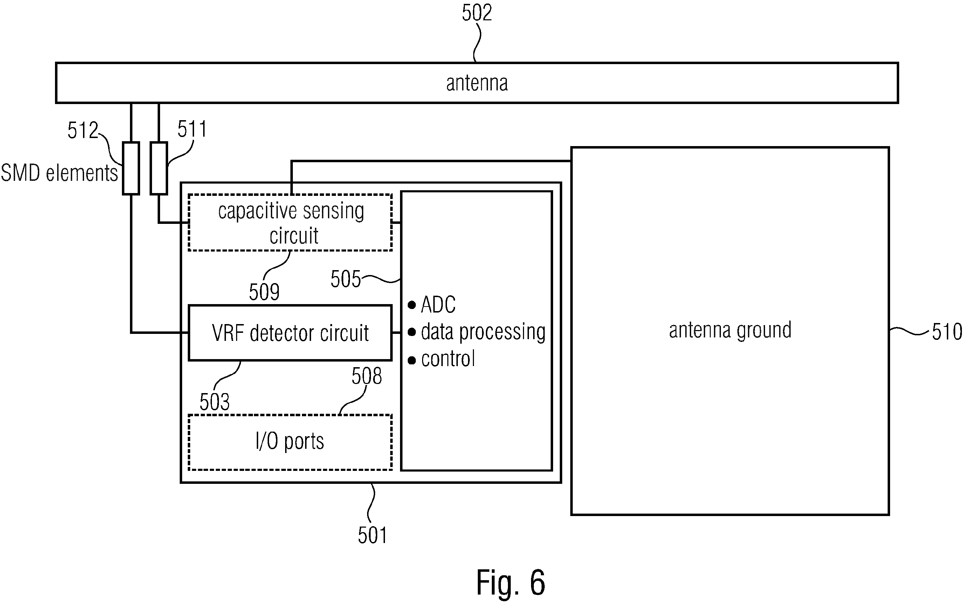

Figure 6 shows a further embodiment, wherein the capacitance sensor 509 may be connected to an antenna ground structure 510. Accordingly, the proximity sensor device 501 may comprise a capacitance sensor 509 for determining a variable capacitance between the antenna 502 and the antenna ground structure 510, wherein the capacitance varies in presence of a body tissue 507 (c.f. Figure 5A). The controller 505 may be configured to determine a proximity of the body tissue 507 relative to the antenna 502 based on the determined capacitance.

Figure 6 is an example how to implement the proposed proximity sensor device 501 with the antenna 502. The optional capacitive sensor 509 may be connected to the antenna 502 and optionally to further conducting structures, e.g. the exemplarily depicted antenna ground structure 510. The proximity sensor device 501 may further comprise optional SMD components 511, 512 that may be used here to decouple the high frequency RF signals for communication from low frequency signals for sensing. The RF voltage sensor 503 may be connected to the antenna 502, and potentially also to a system ground 510. An optional SMD element 512 connected to the RF voltage sensor 503 may be used to minimize the impact of the RF voltage sensor 503 to the high frequency communication signals.

Accordingly, the radio frequency voltage sensor 503 may be galvanically coupled to the antenna 502, and at least one passive electrical component 512 (e.g. an SMD element) may be connected between the antenna 502 and the radio frequency voltage sensor 503, said at least one passive electrical component 512 for minimizing an impact of the radio frequency voltage sensor 503 to high frequency radio waves.

Additionally or alternatively, the optional capacitance sensor 509 may be galvanically coupled to the antenna 502 and to the antenna ground structure 510, and at least one passive electrical component 511 (e.g. an SMD element) may be connected between the antenna 502 and the capacitance sensor 509, said at least one passive electrical component 511 for decoupling low frequency capacitance measurement signals from high frequency radio waves.

As mentioned above, the optional capacitance sensor 509 may be provided in addition to the RF voltage sensor 503. Accordingly, the proximity sensor device 501 may determine a proximity / distance between human body tissue 507 and the antenna 502 based on at least one of the RF voltage sensor 503 and the optional capacitance sensor 509, or based on both the RF voltage sensor 503 and the capacitance sensor 509.

Accordingly, the controller 505 may be configured to determine the proximity / distance based on a first output derived from the radio frequency voltage sensor 503 and based on a second output derived from the capacitance sensor 509.

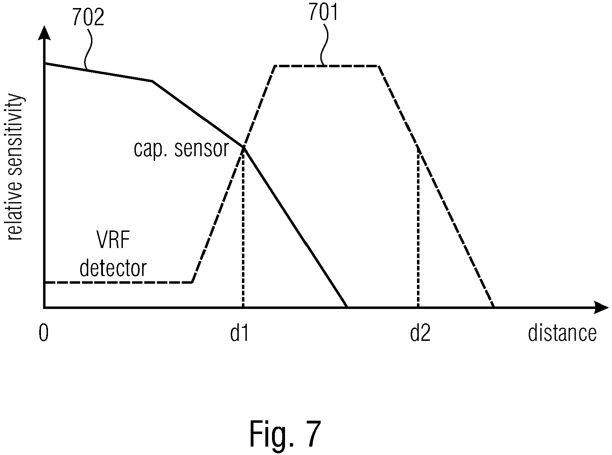

Figure 7 schematically shows one of several advantages of combining the RF voltage sensor 503 with an optional capacitance sensor 509. The graphs 701, 702 depict the relative sensitivity of the RF voltage sensor 503 (c.f. graph 701) and the relative sensitivity of the capacitance sensor 509 (c.f. graph 702), both exemplarily for a mobile phone operating at GSM frequency bands.

The y-axis shows the relative sensitivity, the x-axis shows the proximity / distance of the body tissue 507 relative to the antenna 502. With distance increasing from 0 to d1, the sensitivity of the capacitance sensor 509 is decreasing (graph 702) while the sensitivity of the RF voltage sensor 503 is increasing from d1 to d2. At d2 the sensitivity of the RF voltage sensor 503 begins to reduce. As can be seen, the proposed proximity sensor device having the RF voltage sensor 503 and the capacitance sensor 509 may increase the detecting range of human body tissue 507 from d1 to d2.

However, even if the proposed proximity sensor device 501 may contain the RF voltage sensor 503 only, the detecting range (0 to d2) of human body tissue 507 may still be larger compared to the detecting range (0 to d1) of the capacitance sensor 509 alone.

In other words, the capacitance sensor 509 may be configured to determine the proximity / distance of the body tissue 507 within a first proximity range, and the radio frequency voltage sensor 503 may be configured to determine the proximity / distance of the body tissue 507 within a different second proximity range, wherein the end value (d2) of the second proximity range may be larger than the end value (d1) of the first proximity range.

For example, the first proximity range may comprise a range between 0 mm and 20 mm, and the second proximity range may comprise a range between 10 mm and 30 mm. Accordingly, the capacitance sensor 509 may comprise a good sensitivity within the first proximity range, e.g. from 0 mm to 20 mm, and the RF voltage sensor 503 may comprise a good sensitivity within the second proximity range, e.g. between 10 mm to 30 mm.

According to the above discussed embodiment, the proposed proximity sensor device 501 may operate an RF voltage sensor 503 in combination with a capacitance sensor 509. According to the simulations and analysis of the above mobile phone example, for lower frequency bands below 1 GHz, the RF voltage distribution is very sensitive to the human body proximity within a distance range between 25 mm to 10 mm, where the capacitance sensor 509 instead only has a very low sensitivity. As a result, by implementing a system including the two above mentioned types of sensors 503, 509, the sensing range can be extended from 15 mm to 0 mm (capacitance sensor 509 alone) to 25 mm to 0 mm (capacitance sensor 509 and RF voltage sensor 503).

According to some exemplary embodiments, the antenna 502 may be designed for operating frequencies of 1 GHz and below since the sub-1GHz range is advantageous because the RF voltage distribution is very sensitive in this range.

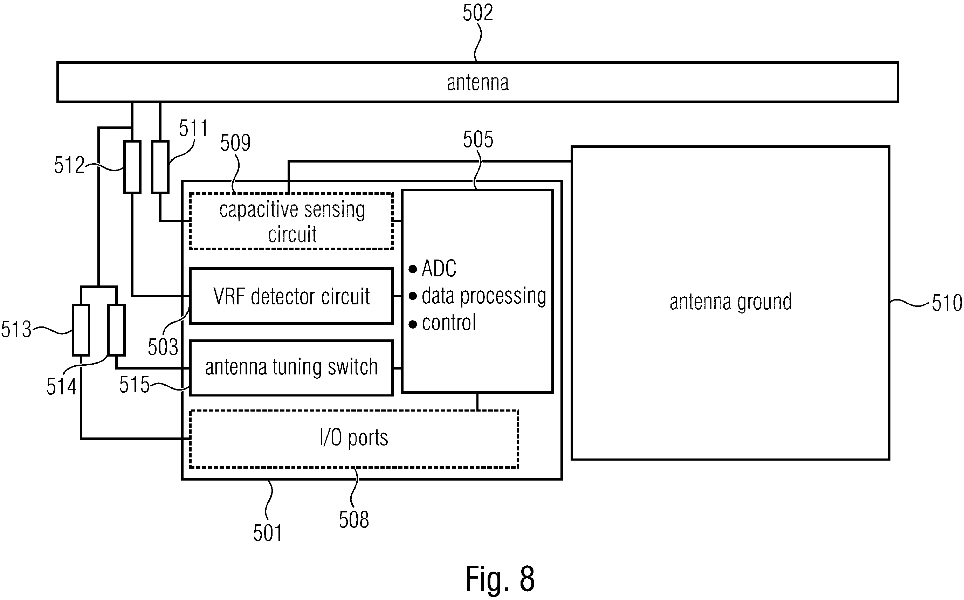

A further embodiment is shown in Figure 8. This embodiment is similar to the one discussed above with reference to Figure 6. Additionally, the embodiment of Figure 8comprises a tunable antenna 502 and an antenna tuning device 515, e.g. an antenna tuning switch. The antenna tuning device 515 may be connected to the controller 505. The controller 505 may control the antenna tuning device 515 for tuning (e.g. de-tuning / re-tuning) the antenna 502 to different operating frequencies. For example, the antenna tuning device 515 may be configured to tune the antenna 502 to operating frequencies of 1 GHz and below.

The antenna tuning device 515 may be coupled to the antenna 502 via passive electrical components 513, 514 (e.g. SMD components). Their purpose is to tune the operating frequencies of the antenna 502.

In some embodiments, it is contemplated that the radio frequency voltage sensor 503 and the capacitance sensor 509 may both be mounted on one common die. The RF voltage sensor 503 may be designed with passive and active elements using diodes, transistors and so on. The proposed proximity sensor device 501 may be realized by a single chip IC or a module including more than one ICs or in a PCB with discrete elements. The proposed proximity sensor device 501 may be implemented in a wireless device and connected to the wireless device's antennas.

Summarizing, the herein described innovative concept provides a Proximity Sensing System 501 (e.g. an SAR sensor system) with an RF voltage detector 503 and, optionally, an additional capacitive sensor 509. The sensor system 501 may comprise integrated antenna tuning switches 510 being utilized with the capacitive sensor 509 and the RF voltage detector 503 in order to extend the range or accuracy of the sensor system 501. The proposed concept will improve the sensitivity of the sensors.

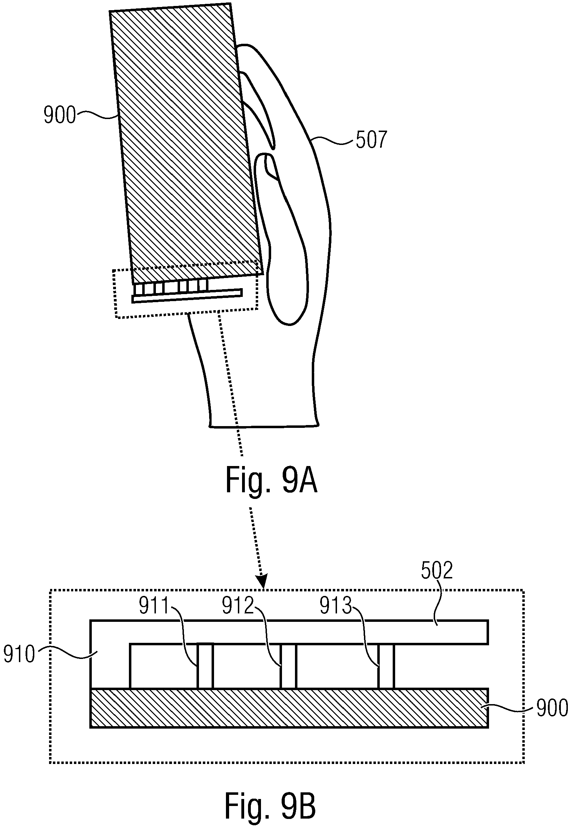

Figures 9A to 9C show a possible integration of the above discussed proposed proximity sensor device 501 into a wireless device 900, e.g. into a smartphone. Figures 9A to 9C show a simulation test setup with a simulation of a user's hand (as an example for human body tissue) 507 in proximity to the wireless device 900.

The wireless device 900 may comprise an antenna 503, which is in this non-limiting example provided as an inverted F-antenna (IFA). As can be seen in Figure 9B, the IFA 502 may comprise a ground pin 910. The RF voltage distribution was simulated at three different exemplary feeding positions, namely at a first feeding position 911 next to the ground pin 910, at a second feeding position 912 further away from the ground pin 910, and at a third feeding position 912 even more further away from the ground pin 910.

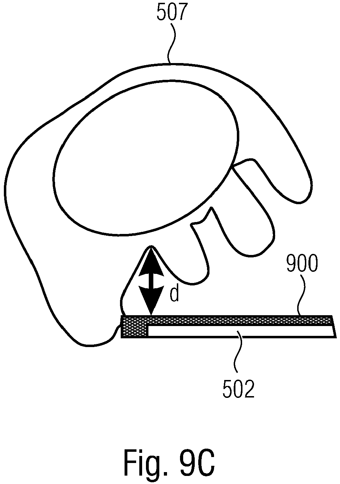

As shown in Figure 9C, the proximity / distance d between the antenna 502 and the user's hand 507 was varied in the simulation. During simulation the RF voltage distribution was analyzed at different antenna positions and with varying distances between the wireless device 900 and the user's hand 507.

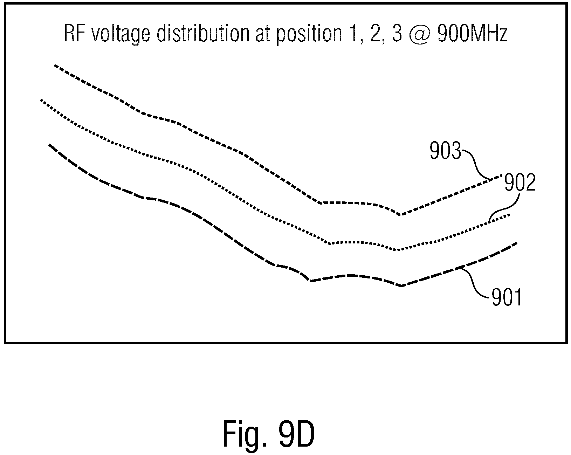

Figure 9D qualitatively show the observed RF voltage distributions at the different feeding positions. In this non-limiting example, the antenna 502 was operated at 900 MHz and with 33 dBm input power. The y-axis shows the amplitude of the measured RF voltage at the antenna 502 with increasing values along the y-axis (from bottom to top). The x-axis shows the distance d between the user's hand 507 and the wireless device 900. It is to be noted that the x-axis starts on the left side with a maximum distance, while the distance values are decreasing when moving farther to the right along the x-axis (i.e. decreasing values for distance d from left to right).

Graph 901 shows the RF voltage distribution of the antenna 502 at the first feeding position 911 (Figure 9B). Graph 902 shows the RF voltage distribution of the antenna 502 at the second feeding position 912 (Figure 9B). Graph 901 shows the RF voltage distribution of the antenna 502 at the third feeding position 913 (Figure 9B). The curve shapes of each graph 901, 902, 903 may be substantially the same. However, the amplitude varies depending on the feeding position 911, 912, 913.

These simulation results may be used to optimize the antenna matching at different frequency bands, e.g. at the 900 MHz band and the 1800 MHz band, respectively, in case of mobile communication, for instance.

With these simulations it could be proven that the proximity of a user's body part 507 may affect the RF voltage distribution of the antenna 502, which can be measured with a RF voltage distribution sensor 503. Accordingly, an RF voltage sensor 503 may be used as a proximity sensor for monitoring whether certain transmit power regulations are met. For instance, an RF voltage sensor 503 may be used as an SAR sensor according to the herein described innovative concept.

Furthermore, it could be proven with the simulation results that the transmit output power of the transmitter 506 and the antenna 502, respectively, could be significantly increased compared with conventional proximity sensor systems that only use a capacitive sensor. As discussed above with reference to Figure 7, the proximity detection range can be increased when using the proposed RF voltage sensor 503.

In particular, when the proximity detection range of the capacitive sensor 509 ends, the transmitter 506 may still reduce the transmit output power in order to be sure that the SAR regulations are met, even though the transmitter 506 may be allowed to provide higher output power. This may result in a case where the transmitter 506 transmits with too low energy resulting in poor wireless performance.

The proposed RF voltage sensor 503 has a larger proximity detection range than the capacitive sensor 509, i.e. the RF voltage sensor 503 may detect a larger proximity / distance of the user's hand 507. Accordingly, the transmit power can be more accurately controlled, even if the user's hand 507 is farther away from the wireless device 900. Therefore, the transmit power can be increased up to the maximum allowed value. According to the above simulations this resulted in a transmit power improvement (compared to a capacitive sensor) of around + 0.5 dB at a distance of 20 mm and even around + 1.0 dB at a distance of 25 mm.

The proposed innovative concept also concerns a wireless communication device 900 comprising a proximity sensor device 501 as. described herein.

Furthermore, the proposed innovative concept also concerns a method for determining a proximity of body tissue 507 relative to an antenna 502, the method comprising a step of providing at least one antenna 502 for transmitting and/or receiving radio frequency waves, a step of determining a variable radio frequency voltage distribution of the antenna 502, wherein the radio frequency voltage distribution varies in presence of the body tissue 507, and a step of determining a proximity of the body tissue 507 relative to the antenna 502 based on the determined radio frequency voltage distribution.

The herein described innovative devices and methods may also be implemented by means of the following embodiments:
According to a first embodiment, a proximity sensor device may be provided comprising at least one antenna for transmitting and/or receiving radio frequency waves, a radio frequency voltage sensor configured to determine a variable radio frequency voltage distribution at the antenna, wherein the radio frequency voltage distribution varies in presence of a body tissue, and a controller configured to determine a proximity of the body tissue relative to the antenna based on the determined radio frequency voltage distribution.

According to a second embodiment, which may be combined with the first embodiment, the controller may be configured to quantify the determined proximity for obtaining a distance measurement value indicating a distance between the body tissue and the antenna.

According to a second embodiment, which may be combined with at least one of the first and second embodiments, the proximity sensor device may further comprise a transmitter for generating a transmit power to be fed to the antenna, wherein the controller may be configured to adjust the transmit power of the transmitter depending on the determined proximity of the body tissue relative to the antenna.

According to a fourth embodiment, which may be combined with the third embodiment, the controller may be configured to provide different transmit powers at different proximities, wherein if the provided transmit power at a certain proximity exceeds a transmit power threshold, then the controller may be configured to decrease the transmit power to a predetermined value, and wherein if the provided transmit power at said certain proximity is below the transmit power threshold, then the controller may be configured to increase the transmit power to said predetermined value.

According to a fifth embodiment, which may be combined with at least one of the preceding embodiments, the proximity sensor device may further comprise a capacitance sensor for determining a variable capacitance between the antenna and an antenna ground structure, wherein the capacitance varies in presence of a body tissue, and the controller may be configured to determine a proximity of the body tissue relative to the antenna based on the determined capacitance.

According to a sixth embodiment, which may be combined with the fifth embodiment, the controller may be configured to determine the proximity based on a first output derived from the radio frequency voltage sensor and based on a second output derived from the capacitance sensor.

According to a seventh embodiment, which may be combined with at least one of the fifth and the sixth embodiment, the capacitance sensor may be configured to determine the proximity of the body tissue within a first proximity range, and the radio frequency voltage sensor may be configured to determine the proximity of the body tissue within a different second proximity range

According to an eighth embodiment, which may be combined with the seventh embodiment, the first proximity range may comprise a range between 0 mm and 20 mm, and the second proximity range may comprise a range between 10 mm and 30 mm.

According to a ninth embodiment, which may be combined with at least one of the fifth to eighth embodiment, the radio frequency voltage sensor and the capacitance sensor may both be mounted on one common die.

According to a tenth embodiment, which may be combined with at least one of the preceding embodiments, the antenna may be designed for operating frequencies of 1 GHz and below.

According to an eleventh embodiment, which may be combined with at least one of the first to ninth embodiment, the antenna may be a tunable antenna, and the proximity sensor device may further comprise an antenna tuning device for tuning the antenna to different operating frequencies.

According to a twelfth embodiment, which may be combined with the eleventh embodiment, the antenna tuning device may be configured to tune the antenna to operating frequencies of 1 GHz and below.

According to a thirteenth embodiment, which may be combined with at least one of the preceding embodiments, the radio frequency voltage sensor may be galvanically coupled to the antenna, and at least one passive electrical component (e.g. an SMD element) may be connected between the antenna and the radio frequency voltage sensor, said at least one passive electrical component for minimizing an impact of the radio frequency voltage sensor to high frequency radio waves.

According to a fourteenth embodiment, which may be combined with at least one of the preceding embodiments, the capacitance sensor may be galvanically coupled to the antenna and to an antenna ground structure, and at least one passive electrical component (e.g. an SMD element) may be connected between the antenna and the capacitance sensor, said at least one passive electrical component for decoupling low frequency capacitance measurement signals from high frequency radio waves.

According to a fifteenth embodiment, a wireless communication device is suggested which comprises a proximity sensor device according to one of the preceding embodiments.

According to a sixteenth embodiment, a method for determining a proximity of body tissue relative to an antenna is suggested, the method comprising steps of providing at least one antenna for transmitting and/or receiving radio frequency waves, determining a variable radio frequency voltage distribution of the antenna, wherein the radio frequency voltage distribution varies in presence of a body tissue, and determining a proximity of the body tissue relative to the antenna based on the determined radio frequency voltage distribution.

According to a seventeenth embodiment, it is suggested to provide a computer readable digital storage medium having stored thereon a computer program having a program code for performing, when running on a computer, the above mentioned method.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments can be implemented in hardware or in software or at least partially in hardware or at least partially in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments comprise a data carrier having electronically readable control signals, which are capable of cooperating with a programmable computer system, such that one of the methods described herein is performed.

Generally, embodiments can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the proposed method is, therefore, a computer program having a program code for performing one of the methods described herein, when the computer program runs on a computer.

A further embodiment of the proposed methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitory.

A further embodiment of the proposed method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The methods described herein may be performed using a hardware apparatus, or using a computer, or using a combination of a hardware apparatus and a computer.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A proximity sensor device (501) comprising
at least one antenna (502) for transmitting and/or receiving radio frequency waves,
a radio frequency voltage sensor (503) configured to determine a variable radio frequency voltage distribution at the antenna (502), wherein the radio frequency voltage distribution varies in presence of a body tissue (507), and
a controller (505) configured to determine a proximity of the body tissue (507) relative to the antenna (502) based on the determined radio frequency voltage distribution.

2. The proximity sensor device (501) of claim 1,
wherein the controller (505) is configured to quantify the determined proximity for obtaining a distance measurement value indicating a distance between the body tissue (507) and the antenna (502).

3. The proximity sensor device (501) according to claim 1 or 2,
further comprising a transmitter (506) for generating a transmit power to be fed to the antenna (502),
wherein the controller (505) is configured to adjust the transmit power of the transmitter (506) depending on the determined proximity of the body tissue (507) relative to the antenna (502).

4. The proximity sensor device (501) according to claim 3,
wherein the controller (505) is configured to provide different transmit powers at different proximities, wherein
if the provided transmit power at a certain proximity exceeds a transmit power threshold, then the controller (505) is configured to decrease the transmit power to a predetermined value, and wherein
if the provided transmit power at said certain proximity is below the transmit power threshold, then the controller (505) is configured to increase the transmit power to said predetermined value.

5. The proximity sensor device (501) according to one of the preceding claims,
further comprising a capacitance sensor (509) for determining a variable capacitance between the antenna (502) and an antenna ground structure (510), wherein the capacitance varies in presence of a body tissue (507), and
wherein the controller (505) is configured to determine a proximity of the body tissue (507) relative to the antenna (502) based on the determined capacitance.

6. The proximity sensor device (501) according to claim 5,
wherein the controller (505) is configured to determine the proximity based on a first output derived from the radio frequency voltage sensor (503) and based on a second output derived from the capacitance sensor (509).

7. The proximity sensor device (501) according to one of claims 5 or 6,
wherein the capacitance sensor (509) is configured to determine the proximity of the body tissue (507) within a first proximity range, and
wherein the radio frequency voltage sensor (503) is configured to determine the proximity of the body tissue (507) within a different second proximity range

8. The proximity sensor device (501) according to claim 7,
wherein the first proximity range comprises a range between 0 mm and 20 mm, and
wherein the second proximity range comprises a range between 10 mm and 30 mm.

9. The proximity sensor device (501) according to one of claims 5 to 8,
wherein the radio frequency voltage sensor (503) and the capacitance sensor (509) are both mounted on one common die.

10. The proximity sensor device (501) according to one of the preceding claims,
wherein the antenna (502) is designed for operating frequencies of 1 GHz and below.

11. The proximity sensor device (501) according to one of claims 1 to 9,
wherein the antenna (502) is a tunable antenna, and
wherein the proximity sensor device (501) further comprises an antenna tuning device (510) for tuning the antenna (502) to different operating frequencies.

12. The proximity sensor device (501) according to claim 11,
wherein the antenna tuning device (510) is configured to tune the antenna (502) to operating frequencies of 1 GHz and below.

13. A wireless communication device (900) comprising a proximity sensor device (501) according to one of the preceding claims.

14. A method for determining a proximity of body tissue (507) relative to an antenna (502), the method comprising:
providing at least one antenna (502) for transmitting and/or receiving radio frequency waves,
determining a variable radio frequency voltage distribution of the antenna (502), wherein the radio frequency voltage distribution varies in presence of the body tissue (507), and
determining a proximity of the body tissue (507) relative to the antenna (502) based on the determined radio frequency voltage distribution.

15. A computer readable digital storage medium having stored thereon a computer program having a program code for performing, when running on a computer, a method according to claim 14.
